# EUROPÄISCHE PATENTSCHRIFT

(11) **EP 1 997 565 B1**
(45) Veröffentlichungstag und Bekanntmachung des Hinweises auf die Patenterteilung: **02.12.2015**
(21) Anmeldenummer: 08158940.0
(22) Anmeldetag: 28.06.2002
(51) Int. Cl.: B05D 7/24, B05D 5/08, B08B 17/06

(54) **Artikel mit plasmapolymerer Beschichtung und Verfahren zu dessen Herstellung**
Article with plasmopolymeric coating and method for its manufacture
Article doté d'un revêtement en polymère plasma et son procédé de fabrication

(30) Priorität: 29.06.2001 DE 10131156
(43) Veröffentlichungstag der Anmeldung: 03.12.2008
(62) Teilanmeldung aus: 02738176.3
(73) Patentinhaber: Fraunhofer-Gesellschaft zur Förderung der angewandten Forschung e.V., 80686 München (DE)
(72) Erfinder: Vissing, Klaus-Dieter, 27321 Thedinghausen (DE); Ellinghorst, Guido, 28355 Bremen (DE); Neese, Gabriele, 28215 Bremen (DE)
(74) Vertreter: Eisenführ Speiser

(56) Entgegenhaltungen:
- EP-A- 0 960 958
- EP-A- 1 123 991
- EP-A- 1 260 606
- WO-A-99/22878
- DE-A- 10 034 737
- DE-A- 10 047 124
- DE-A- 10 056 564
- DE-C- 19 921 303
- US-A- 5 230 929

## Beschreibung

Die vorliegende Erfindung betrifft Artikel mit einer plasmapolymeren Beschichtung sowie Verfahren zur Herstellung derartiger Artikel.

Artikel mit einer plasmapolymeren Beschichtung sind seit längerem bekannt.

So werden bereits in der DE 42 16 999 A1 Silbergegenstände beschrieben, welche eine plasmapolymere Beschichtung aufweisen. Die Beschichtungen besitzen aufgrund einer schrittweisen Variation der Verfahrensparameter einen Schichtaufbau, wobei insbesondere eine Kopplungsschicht, eine permeationsverhindernde Schicht und eine harte, kratzfeste Oberflächenversiegelung unterschieden werden können. Zur Herstellung der kratzfesten Schicht wird ein Gemisch aus Sauerstoff (O₂) und Hexamethyldisiloxan (HMDSO) eingesetzt. Das genaue Mengenverhältnis von O₂ und HMDSO wird jedoch ebenso wenig angegeben wie die Struktur oder Zusammensetzung der kratzfesten Schicht selbst.

Darüber hinaus lassen sich die mehrlagigen Beschichtungen, die in der DE 42 16 999 A1 offenbart werden, leicht wieder vom Silbersubstrat entfernen.

In der DE 195 43 133 A1 ist ein Verfahren zur Erzeugung dünner, stark hydrophober Polymerschichten mittels Plasmapolymerisation beschrieben. Zur Plasmapolymerisation werden als Monomere Vinylmethylsilan und Vinyltrimethoxysilan angegeben, bei denen es sich um Monomere handelt, die mindestens eine Gruppe mit einer geringen Affinität zu Sauerstoff aufweisen und die sich unter weitgehendem Strukturerhalt plasmapolymerisieren lassen. Den genannten Monomeren können nicht-polymerisierbare Gase wie z.B. Edelgas, Stickstoff oder Wasserstoff als Hilfs- oder Trägergas zugesetzt sein, um die Homogenität des Plasmas zu verbessern und um den Druck in der Gasphase zu erhöhen.

In der DE 197 48 240 A1 werden Verfahren zur korrosionsfesten Beschichtung von Metallsubstraten mittels Plasmapolymerisation beschrieben, wobei das Metallsubstrat zunächst in einem ersten Vorbehandlungsschritt einer mechanischen, chemischen und/oder elektrochemischen Glättung und dann in einem zweiten Verfahrensschritt einer Plasmaaktivierung unterzogen wird, bevor dann die plasmapolymere Beschichtung appliziert wird. Als Hauptbestandteil des Plasmapolymeren werden kohlenwasserstoff- und/oder siliziumorganische Verbindungen angegeben, wobei der Einsatz von Hexamethyldisiloxan und Hexamethylcyclotrisiloxan als besonders bevorzugt bezeichnet wird. In den Beispielen der DE 197 48 240 A1 wird Hexamethyldisiloxan eingesetzt, wobei als Zusatzgase Sauerstoff und Stickstoff beigemischt sein können.

Es fehlen in der DE 197 48 240 A1 jedoch Angaben zum Verhältnis von Monomer und Sauerstoff ebenso wie Angaben zur Struktur und chemischen Zusammensetzung der resultierenden plasmapolymeren Beschichtung. Zudem lehrt die DE 197 48 240 A1 nicht, wie und auf welchem Substrat eine plasmapolymere Beschichtung appliziert werden muss, um eine besonders leicht zu reinigende Oberfläche bereitzustellen.

Leicht zu reinigende Oberflächen werden aber in einer Vielzahl von Anwendungsbereichen gefordert. So sollen beispielsweise Felgen für Automobile nicht nur korrosionsfest und gegen Steinschlag geschützt sondern gleichzeitig auch leicht zu reinigen sein.

In der WO 96/04123 (Wilhelm Barthlott) wurden bereits sogenannte selbstreinigende Oberflächen von Gegenständen beschrieben, die durch eine Oberflächenstruktur aus Erhebungen und Vertiefungen gekennzeichnet sind. Der Abstand zwischen den Erhebungen muss dabei im Bereich von 5 bis 200 µm und die Höhe der Erhebungen im Bereich von 5 bis 100 µm liegen. Zumindest die Erhebungen sollen aus hydrophoben Polymeren oder haltbar hydrophobierten Materialien bestehen.

Die in der WO 96/04123 beschriebenen Effekte wurden unter der Bezeichnung "Lotus-Effekt" populär.

In eigenen, bislang noch nicht veröffentlichten Arbeiten haben wir uns mit den Auswirkungen von Oberflächenstrukturen auf die Schmutzanhaftungs- und Selbstreinigungs-Eigenschaften plasmapolymer beschichteter Artikel befasst. Dabei fanden wir die unter dem Begriff Lotus-Effekt zusammengefassten Erkenntnisse bestätigt.

Um so überraschender erscheint es daher, dass besonders hochwertige, d.h. besonders leicht zu reinigende (selbstreinigende) plasmapolymere Oberflächen auch ohne Vorsehen einer den Lotus-Effekt hervorrufenden Oberflächenstruktur aus Erhebungen und Vertiefungen erhältlich sind, wenn die Zusammensetzung und die Struktur der Oberfläche bestimmte Bedingungen erfüllt.

Erfindungsgemäße leicht zu reinigende Artikel, umfassen ein Substrat und eine flächig mit dem Substrat verbundene plasmapolymere, Silizium, Sauerstoff und Kohlenstoff umfassende Beschichtung, für die gilt:
- Das Stoffmengenverhältnis O : Si ist > 1,25, bevorzugt > 1,35, weiter bevorzugt > 1,4
- und gleichzeitig < 2,6, bevorzugt < 2,0, weiter bevorzugt < 1,9
- und das Stoffmengenverhältnis C : Si ist > 0,6, bevorzugt > 1,00, weiter bevorzugt 1,2, wiederum bevorzugt > 1,29
- und gleichzeitig < C 2,2, bevorzugt < 1,76, weiter bevorzugt < 1,7
vermessen mit ESCA (Elektronenspektroskopie für die chemische Analyse) bevorzugt an der dem Substrat abgewandten Seite (nähere Angaben zur Messung finden sich weiter unten). Dabei ist mit "Stoffmengenverhältnis X:Y" hier und weiter unten das Verhältnis (nₓ : n_{y}) zu verstehen.

Neben den genannten Elementen Sauerstoff, Kohlenstoff und Silizium umfasst die plasmapolymere Beschichtung Wasserstoff (mit ESCA nicht nachweisbar) und/oder Fluor, wobei gilt:
1,8 : 1 < n (H und/oder F) : n (C) < 3,6 : 1
   vorzugsweise
2,2 : 1 < n (H und/oder F) : n (C) < 3,3 : 1

Die Messungen des Wasserstoffanteils wurden per Mikroelementanalyse durchgeführt, bei der zunächst ein Salzkristall beschichtet wurde, so dass die Beschichtung in einem Wasserbad abgelöst werden konnte. Die abgelöste Schicht wurde bei 100°C bis zur Gewichtskonstanz getrocknet. Dann wurden die Masseprozente für Wasserstoff und Kohlenstoff bestimmt.

Die erfindungsgemäßen Artikel lassen sich weitgehend unabhängig von ihrer Oberflächenstruktur leicht reinigen.

Die erfindungsgemäße plasmapolymere Beschichtung umfasst vorzugsweise, bezogen auf ihre Gesamtatomzahl ohne Wasserstoff und/oder Fluor,
- minimal 22, bevorzugt 23, weiter bevorzugt 23,9 und maximal 27, bevorzugt 26,1, weiter bevorzugt 25 Atomprozente Si,
- minimal 25, bevorzugt 31, weiter bevorzugt 34,2 und maximal 50, bevorzugt 47, weiter bevorzugt 40,2 Atomprozente O und
- minimal 25, bevorzugt 27" weiter bevorzugt 33,8 und maximal 50, bevorzugt 44, weiter bevorzugt 40,4 Atomprozente C
vermessen mit ESCA (Elektronenspektroskopie für die chemische Analyse) bevorzugt an der dem Substrat abgewandten Seite (nähere Angaben zur Messung finden sich weiter unten).

In manchen Fällen ist es vorteilhaft, eine (im wesentlichen) fluorfreie oder eine (im wesentlichen) wasserstofffreie Schicht zu erzeugen. Darüber hinaus treten bei Wahl der oben genannten bevorzugten Bereiche für die Zusammensetzung der Schicht aus Silizium, Kohlenstoff und Sauerstoff sowie ggf. Wasserstoff und/oder Fluor deutliche Verbesserungen bezüglich einzelner oder mehrerer der nachfolgend genannten Eigenschaften auf:
- thermische Stabilität
- chemische Stabilität
- mechanische Stabilität
- Hydrophobie (quantifizierbar durch Angabe des Wasserrandwinkels)
- Härte

Das Substrat kann aus unterschiedlichen Materialien bestehen, beispielsweise aus Kunststoff, Lack, Metall, Keramik oder Glas. Das im Einzelfall ausgewählte Substratmaterial wird entweder unmittelbar, d.h. ohne Vorbehandlung, mit der plasmapolymeren Beschichtung versehen, oder es wird oberflächlich zuvor gereinigt und/oder aktiviert und/oder mit einem plasmapolymeren Haftvermittler versehen.

Besonders leicht zu reinigen sind erfindungsgemäße Artikel, bei denen der Rauwert Rₐ (bestimmt nach DIN 4768) einer die Oberfläche bildenden plasmapolymeren Beschichtung einen Wert von unter 1 µm, bevorzugt einen Wert von weniger als 0,3 µm und weiter bevorzugt einen Wert von weniger als 0,1 µm besitzt. Die Oberfläche der Beschichtung ist somit extrem glatt, was im unmittelbaren Widerspruch zu den unter dem Begriff Lotus-Effekt zusammengefassten Erkenntnissen steht.

Plasmapolymere Beschichtungen sind konturnachbildend, so dass sich entsprechend Substrate mit entsprechend glatten Oberflächen besonders gut eignen, um leicht zu reinigende Artikel herzustellen. Metallische Substrate können zum Erreichen einer sehr glatten Oberfläche einer mechanischen, chemischen und/oder elektrochemischen Glättung unterwerfen werden, wie sie beispielsweise in der DE 197 48 240 A1 beschrieben ist. Einer derartigen Glättung eines metallischen Substrates kann sich eine Oberflächenbehandlung mittels eines reduktiv eingestellten Plasmas, insbesondere eines Wasserstoffplasmas anschließen, wie sie ebenfalls in der DE 197 48 240 A1 beschrieben ist, und bei Einsatz metallischer Substrate wird diese Behandlung insbesondere dann vorgesehen sein, wenn die erfindungsgemäße zusammengesetzte plasmapolymere Beschichtung dauerhaft mit dem metallischen Substrat verbunden sein soll.

Sollen nicht-metallische Substrate beschichtet werden, also beispielsweise Kunststoffe, Lacke, Keramiken oder Gläser, so wird ggf. ebenfalls eine Glättungsvorbehandlung durchgeführt, damit die Substratoberfläche bereits so glatt ist wie die Oberfläche der nachfolgend zu applizierenden plasmapolymeren Beschichtung. Gegebenenfalls wird die Substratoberfläche aktiviert und/oder mit einem Haftvermittler versehen.

Um niedrige Festkörperoberflächenenergien erzeugen zu können sind neben CH₃ - Gruppen insbesondere CF₃ - Gruppen von Interesse. Dabei ist es egal, ob diese Gruppen in Mischung vorkommen oder alleinig. Als Precursor können z.B. zum Einsatz kommen: CF₄, C₂F₈ oder (3,3,3-Trifluoropropyl) Trimethoxysilan und Trifluoromethyltrimethylsilan. Es können auch Mischungen von Precursorn verwendet werden, solange die Erzeugung von CH₃ bzw. CF₃ - Gruppen gewährleistet ist.

Vorzugsweise besitzt eine plasmapolymere Beschichtung, welche die Oberfläche eines erfindungsgemäßen Artikels bildet, einen Wasserrandwinkel > 90°, vorzugsweise > 95°, weiter vorzugsweise > 100°. Zum Erreichen der genannten Wasserrandwinkel wird der Fachmann geeignete Precursor bzw. Precursormischungen (Gasverhältnisse) auswählen und geeignete Betriebsparameter der Plasmaanlage einstellen, d.h. insbesondere den Druck, die Durchflussrate des Precursors und die Leistung (bei der elektrischen Entladung).

Bevorzugt ist zur Applikation der plasmapolymeren Beschichtung der Einsatz eines Nichtgleichgewichts-Plasmas. Sowohl Niederdruck- als auch Atmosphären-druckplasmen können eingesetzt werden.

Die Reinigung erfolgt bevorzugt auf wässriger Basis, mit und ohne Reinigungsmittel. Nichtsdestotrotz können auch übliche Industriereiniger eingesetzt werden. Zu vermeiden ist jedoch zum Erhalt einer Dünnschicht das Reiben mit scharfen Objekten, wie z.B. Sand oder Späne im Lappen. Von Vorteil ist das Nachspülen mit klarem Wasser.

Bei den erfindungsgemäßen Artikel kann es sich insbesondere um einen der folgenden Gegenstände handeln: Felge; Radkappe; Aluminiumprofil, insbesondere für Fenster oder Duschen; Fenster; Verkleidungen (innen und außen), insbesondere für Automobile, Flugzeuge oder Schienenfahrzeuge; Windradflügel; Flugzeugaußenhaut oder Bereiche hiervon; Metallverblendung, insbesondere für Häuser; Verblendung und Verkleidungen für Küchen bzw. Küchengeräten; Display, insbesondere für Küchen; Verglasung; Automobilkarosserieteil; Motorradbauteil; Getränkebehälter; Farbbehälter; Tintenbehälter; Tuschepatrone; Flasche; Küchengerät; Bratpfanne; Hinweisschild; Warnzeichen; wiederverwendbare Gefäße für Lebensmittel, wie z.B. Flaschen oder Fässer.

Diese Gegenstände werden in der Regel nicht vollständig mit einer plasmapolymeren Beschichtung versehen sein, sondern nur in den Bereichen, in denen es auf eine leichte Reinigung ankommt.

Bevorzugte plasmapolymere Beschichtungen zeichnen sich durch einzelne oder mehrere der folgenden Eigenschaftskennwerte aus:

| | |
|---|---|
| Härte | ca. 1,4 ± 0,1 GPa |
| E- Modul | ca. 7,9 ± 0,3 GPa |
| Bleistifthärte | Fehlerfrei bis 2H |
| Oberflächenenergie | etwa 25 bis 30 mN/m |
| UV - Stabilität | mind. 1000 Std. erfüllt nach DIN 50010 |
| Transparenz | Transparent im sichtbaren Spektralbereich |
| Thermische Stabilität | ca. 350°C |
| Chemische Stabilität (bei RT) | z.B.: Aceton, Cyclohexan, Ethanol, Toluol |
| Schichtdicke | 1 nm - 1µm |

Für bevorzugte plasmapolymere Beschichtungen wurden ESCA - Spektren aufgenommen und ausgewertet (Tabelle 1). Dabei wurde kein H erfasst. In den Beispielen sind die Energiemaxima und die Halbwertsbreiten (FWHM) der einzelnen Peaks angegeben. Zu der Herstellungsverfahrenausgestaltung siehe weiter unten.

Die ESCA - Untersuchungen wurden mit einem Spektrometer ESCALAB 220 -XL der Firma VG durchgeführt: Die Analysekammer ist mit einer Röntgenquelle für monochromatisierte Al K_{α} - Strahlung, einer Elektronenquelle als Neutralisator und einen Quadrupolmassenspektrometer ausgerüstet. Weiterhin verfügt die Anlage über eine magnetische Linse, welche die Photoelektronen auf den Halbkugelanalysator fokussiert.

Das Spektrometer eignet sich aufgrund der hohen Intensität und Energieauflösung (monochromatisierte Al K_{α} - Strahlung) besonders zur Analyse dünner organischer Schichten.

Die Transmissionsfunktion des Spektrometers wurde mit einer sauberen Silberprobe bestimmt. Die Sensitivitätsfaktoren für C1s, O1s und Si2p wurden mit trimethylsiloxyterminiertem PDMS (Polydimethylsiloxan) mit Mₘ = 64000 g/mol als Referenzmaterial bestimmt.

**Tabelle 1: Ergebnisse der ESCA - Analysen zu bevorzugten plasma-polymeren Beschichtungen. Die Angaben in Atomprozent beziehen sich auf die Gesamtzahl der O, C und Si-Atome der jeweiligen Schicht (Σ Atomprozent (O, C, Si) = 100)**

| | **O 1s** | **C 1s** | **Si 2p** |
|---|---|---|---|
| | Menge [Atomprozent] | Menge [Atomprozent] | Menge [Atomprozent] |
| | Energiemax. [eV] | Energiemax. [eV] | Energiemax. [eV] |
| | FWHM [eV] | FWHM [eV] | FWHM [eV] |
| **Beispiel 1** | 39,5 | 36,5 | 24,0 |
| (NiederdruckPlasma) | 532,90 | 285,0 | 102,95 |
| | 1,40 | 1,40 | 2,0 |
| **Beispiel 2** | 46,0 | 30,0 | 24,0 |
| (NiederdruckPlasma) | 532,95 | 285,0 | 103,20 |
| | 1,60 | 1,50 | 2,1 |
| **Beispiel 3** | 51,8 | 19,6 | 28,6 |
| (Atmosphärendruckplasma) | 533,2 | 285,0 | 103,55 |
| | 1,41 | 1,24 | 1,98 |
| **Beispiel 4** | 42,0 | 32,5 | 25,5 |
| (Atmosphärendruckplasma) | 532,85 | 532,85 | 103,05 |
| | 1,58 | 1,32 | 1,85 |

Die vorliegende Erfindung betrifft auch Verfahren zur Herstellung von Artikeln mit einer plasmapolymeren Beschichtung. Nachfolgend werden bevorzugte Verfahrensausgestaltungen und daraus resultierende erfindungsgemäße Artikel für die in Tabelle 1 angegebenen Beispiele 1-4 plasmapolymerer Beschichtungen näher erläutert:

### Zu Beispiel 1:

Die Oberfläche eines metallischen Substrats mit einem Rₐ-Wert nach DIN 4768 (= arithmetisches Mittel der absoluten Beträge aller Abweichungen des Rauheitsprofils von der Mittellinie) von 300 nm wurde mittels eines reduktiv eingestellten Plasmas aktiviert.

Anschließend wurde eine plasmapolymere Beschichtung appliziert, wobei das Plasma aus Sauerstoff (O₂) und Hexamethyldisiloxan (HMDSO) gebildet war. Das Verhältnis von Sauerstoff zu HMDSO wurde dabei so eingestellt, dass der Gasfluss an HMDSO etwa halb so groß war wie der Gasfluss an O₂. Die genauen Verfahrensparameter für die Abscheidung der die Oberfläche bildenden Beschichtung waren:

| | |
|---|---|
| Gasfluss O₂: | 260 cm³/min |
| Gasfluss HMDSO: | 120 cm³/min |
| Leistung (W): | 4000 |
| Zeit (sec): | 300 |
| Druck (mbar): | 0,045. |

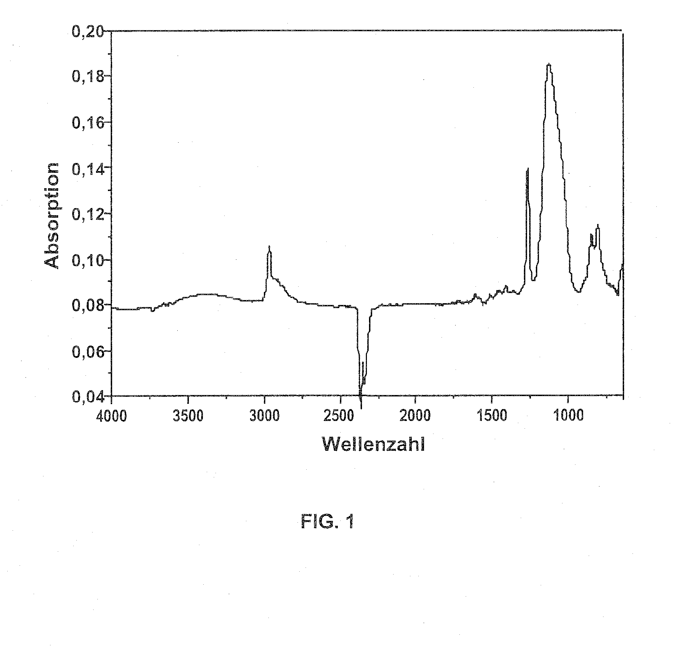

Ein FTIR - Spektrum, der die Oberfläche des Artikels bildenden plasmapolymeren (Antischmutz-) Beschichtung ist als Fig. 1 beigefügt.

Das Stoffmengenverhältnis von Sauerstoff zu Silizium betrug gemäß Tabelle 1 daher etwa:
n (O) : n (Si) = 1,65 : 1
und das Verhältnis von Kohlenstoff zu Silizium betrug gemäß Tabelle 1 etwa:
n (C) : n (Si) = 1,52 : 1.

Die plasmapolymere Beschichtung zeigte eine gute chemische und mechanische Stabilität sowie hydrophobes Verhalten. Sie neigte nicht zur Bildung von Rissen aufgrund von Eigenspannungen (wie es z.B. quarzglasähnliche Schichten mit einem Stoffmengenverhältnis n (O): n (Si) von etwa 2:1 tun).

Zusätzlich wurde eine Mikroelementaranalyse für Wasserstoff und Kohlenstoff durchgeführt. Hierzu wurde zunächst ein Salzkristall unter den gleichen Bedingungen wie vorstehend angegeben beschichtet, so dass die Beschichtung in einem Wasserbad abgelöst werden konnte. Die abgelöste Schicht wurde bei 100°C bis zur Gewichtskonstanz getrocknet. In einer Doppelmessung wurden dann folgende Masseprozente gefunden:

**Tabelle 2: Wasserstoff- und Kohlenstoffgehalt der leicht zu reinigenden Oberfläche**

| Element | Masseprozent [%] | Mittelwert Masseprozent [%] | Mittelwert Masseprozent / Molmasse [mol / 100 g der Schicht] |
|---|---|---|---|
| C | 19,6 ; 20,0 | 19,8 | 1,65 |
| H | 4,25 ; 4,34 | 4,30 | 4,30 |

Hieraus ergibt sich ein H / C - Atomzahlenverhältnis von 2,61 : 1.

### Zu Beispiel 2:

Die Oberfläche einer lackierten Autofelge (handelsüblicher Acryl - Pulverlack mit einem Rₐ-Wert nach DIN 4768 von 0,4 µm wurde mittels eines Sauerstoffplasmas aktiviert.

Anschließend wurde eine plasmapolymere Beschichtung appliziert, wobei das Plasma aus Sauerstoff (O₂) und Hexamethyldisiloxan (HMDSO) gebildet war. Das Verhältnis von Sauerstoff zu HMDSO wurde dabei so variiert, dass der Gasfluss an HMDSO zuletzt zum Gasfluss an O₂ im Verhältnis von 27,5:100 stand. Die genauen Verfahrensparameter für die Abscheidung der die Oberfläche bildenden Beschichtung waren zuletzt:

| | |
|---|---|
| Gasfluss O₂: | 100 cm³/min |
| Gasfluss HMDSO: | 27,5 cm³/min |
| Leistung (W): | 2500 |
| Zeit (sec): | 300 |
| Druck (mbar): | 0,03. |

Das FTIR - Spektrum in der die Oberfläche des Artikels bildenden plasmapolymeren (Antischmutz)-Beschichtung entspricht im Wesentlichen dem in Fig. 1 zu Beispiel 1 dargestellten Spektrum.

Das Stoffmengenverhältnis von Sauerstoff zu Silizium betrug etwa:
n (O) : n (Si) = 1,92 : 1
und das Verhältnis von Kohlenstoff zu Silizium betrug etwa:
n (C) : n (Si) = 1,25 : 1.
und das Verhältnis von Wasserstoff zu Kohlenstoff betrug etwa:
n (H) : n (C) = 3,1 : 1.

Die mit dem Plasmapolymeren beschichtete Felge entsprach optisch der nicht beschichteten, lackierten Felge, die als Substrat eingesetzt worden war.

In Tests zeigte sich, dass die plasmapolymere Antischmutz-Beschichtung hoch hitzebeständig war (bis zu Temperaturen von etwa 360°C).

Im Vergleich mit der als Substrat eingesetzten lackierten Felge, bei der es sich um ein handelsübliches Produkt handelte, verschmutzte die gemäß Beispiel 2 hergestellte Felge im Betrieb langsamer und es entstanden keine Mikrorisse in der Lackierung, wie sie bei der Verwendung handelsüblicher Felgen unvermeidlich auftreten. Bremsstaub - Einbrennungen, wie sie bei der handelsüblichen Vergleichsfelge festgestellt wurden, waren bei der auf erfindungsgemäße Weise hergestellten Felge nicht festzustellen.

Oberflächliche Verschmutzungen durch Bremsstaub der erfindungsgemäßen Felge ließen sich bereits durch Regenwasser leicht abspülen; eine Behandlung in einer Autowaschanlage führte selbstverständlich ebenfalls zu einer rückstandsfreien Reinigung der Felge.

### Zu Beispiel 3:

Die Beschichtung in diesem Beispiel ist im Gegensatz zu den anderen beiden Beispielen mit Hilfe der Atmosphärendruckplasmapolymerisation hergestellt worden. Hierzu ist ein Plasmawerkzeug benutzt worden, wie es in der Patentschrift DE 195 32 412 C2 beschrieben wurde.

Die wichtigsten Parameter zur Abscheidung dieser funktionalen und transparenten Schicht sind:

| | |
|---|---|
| lonisationgas: | Stickstoff, 150 l/min |
| Precursor: | HMDSO, 3 g/min |
| mittlere Zwischenkreisspannung | |
| (für Anordnung von 7 Düsen): | 450 V |
| Abstand zwischen Substrat und Düse: | 15 mm |
| Verfahrgeschwindigkeit: | 100 m/min |

Hiermit konnten Displays für Herde beschichtet werden. Die so beschichteten Displays lassen sich im Vergleich zu unbeschichteten Displays sehr leicht reinigen. Bei Bedarf lassen sich die Schichten auch in einer solchen Dicke auftragen, dass zusätzlich ein Kratzschutz entsteht.

Hiermit konnten Displays für Herde beschichtet werden. Die so beschichteten Displays lassen sich im Vergleich zu unbeschichteten Displays sehr leicht reinigen. Bei Bedarf lassen sich die Schichten auch in einer solchen Dicke auftragen, dass zusätzlich ein Kratzschutz entsteht.

### Zu Beispiel 4:

Die funktionale und transparente Beschichtung wurde wie Beispiel 3 aber mit folgenden Parametern hergestellt:

| | |
|---|---|
| lonisationgas: | Stickstoff, 120 l/min |
| Precursor: | HMDSO, 2 g/min |
| mittlere Zwischenkreisspannung | |
| (für Anordnung von 7 Düsen): | 400 V |
| Abstand zwischen Substrat und Düse: | 30 mm |
| Verfahrgeschwindigkeit: | 20 m/min |

Auch hiermit konnten Displays für Herde beschichtet werden. Die so beschichteten Displays lassen sich im Vergleich zu unbeschichteten Displays sehr leicht reinigen. Gegenüber der Schicht aus Beispiel 3 ist bei der Schicht aus Beispiel 4 die chemische, thermische und mechanische Stabilität deutlich verbessert, was auf die veränderte Schichtzusammensetzung (verl. Tabelle 1) zurückzuführen ist.

## Patentansprüche

1. Artikel, umfassend
- ein Substrat
- und eine flächig mit dem Substrat verbundene plasmapolymere, Silizium, Sauerstoff und Kohlenstoff umfassende Beschichtung, für die bei Bestimmung der Stoffmengenverhältnisse in der plasmapolymeren Beschichtung auf der vom Substrat abgewandten Seite mittels ESCA gilt:
- Das Stoffmengenverhältnis O : Si ist > 1,25 und < 2,6
- und das Stoffmengenverhältnis C : Si ist > 0,6 und < 2,2,
wobei die plasmapolymere Beschichtung Wasserstoff und/oder Fluor umfasst, wobei gilt:
1,8 : 1 < n (H und/oder F): n (C) < 3,6 : 1
vorzugsweise
2,2 : 1 < n (H und/oder F): n (C) < 3,3 : 1.

2. Artikel nach Anspruch 1, wobei die Beschichtung bezogen auf ihre Gesamtatomzahl ohne Wasserstoff und/oder Fluor
- minimal 22 und maximal 27 Atomprozente Si,
- minimal 25 und maximal 50 Atomprozente O und
- minimal 25 und maximal 50 Atomprozente C
enthält.

3. Artikel nach Anspruch 1,
**dadurch gekennzeichnet, dass** der Rauwert Rₐ der Oberfläche der plasmapolymeren Beschichtung kleiner ist als 1 µm, vorzugsweise kleiner als 0,3 µm, und weiter vorzugsweise kleiner als 0,1 µm.

4. Artikel nach einem der vorangehenden Ansprüche,
**dadurch gekennzeichnet, dass** die plasmapolymere Beschichtung einen Wasserrandwinkel von über 90°, vorzugsweise über 95° vorzugsweise über 100° besitzt.

5. Artikel nach einem der vorangehenden Ansprüche,
**dadurch gekennzeichnet, dass** die plasmapolymere Beschichtung über eine Zwischenschicht mit dem Substrat verbunden ist.

6. Artikel nach einem der vorangehenden Ansprüche,
**dadurch gekennzeichnet, dass** es sich bei dem Artikel um einen der folgenden Gegenstände handelt:
Felge; Radkappe; Aluminiumprofil, insbesondere für Fenster oder Duschen; Fenster; Verkleidungen; Windradflügel; Metallverblendung, insbesondere für Häuser; Verblendung und Verkleidungen für Küchen bzw. Küchengeräten; Display, insbesondere für Küchen; Verglasung; Automobilkarosserieteil; Motorradbauteil; Getränkebehälter; Farbbehälter; Tintenbehälter; Tuschepatrone; Flasche; Küchengerät; Bratpfanne; Hinweisschild; Warnzeichen; wiederverwendbare Gefäße für Lebensmittel, wie z.B. Flaschen oder Fässer.

## Claims

1. An article, comprising
- a substrate
- and a plasma polymer coating comprising silicon, oxygen and carbon which is joined in surface-to-surface contact to the substrate, for which coating the following applies when determining the substance ratios in the plasma polymer coating on the side remote from the substrate by means of ESCA:
- the substance ratio O : Si is > 1.25 and < 2.6
- and the substance ratio C : Si is > 0.6 and < 2.2,
wherein the plasma polymer coating comprises hydrogen and/or fluorine, wherein the following applies:
1.8 : 1 < n (H and/or F): n (C) < 3.6 :1
preferably
2.2 : 1 < n (H and/or F): n (C) < 3.3 :1.

2. An article according to Claim 1, wherein the coating contains relative to its total atomic number without hydrogen and/or fluorine
- at least 22 and at most 27 atomic percent Si,
- at least 25 and at most 50 atomic percent O and
- at least 25 and at most 50 atomic percent C

3. An article according to Claim 1,
**characterised in that** the roughness value Rₐ of the surface of the plasma polymer coating is less than 1 µm, preferably less than 0.3 µm, and furthermore preferably less than 0.1 µm.

4. An article according to one of the preceding claims,
**characterised in that** the plasma polymer coating has a water contact angle of more than 90°, preferably of more than 95°, preferably of more than 100°.

5. An article according to one of the preceding claims,
**characterised in that** the plasma polymer coating is joined to the substrate via an intermediate layer.

6. An article according to one of the preceding claims,
**characterised in that** the article is one of the following objects:
rim; hub cap; aluminium profile, in particular for windows or showers; window; trims; wind turbine blades; metal veneers, in particular for houses; veneer and trims for kitchens or kitchen implements; display, in particular for kitchens; glazing; automobile body part; motorcycle component; drinks container; paint container; ink container; ink cartridge; bottle; kitchen implement; frying-pan; sign; warning sign; reusable vessels for foodstuffs, such as bottles or barrels.

## Revendications

1. Article comprenant:
- un substrat,
- et un revêtement de surface reliant des polymères à plasma reliés au substrat comprenant du silicium, de l'oxygène et du carbone, pour lequel, lors de la détermination des rapports molaires dans le revêtement polymère à plasma sur le côté opposé du substrat au moyen d'une analyse ESCA, s'appliquent :
- le rapport molaire O : Si supérieur à > 1,25 et inférieur à < 2,6
- et le rapport molaire C : Si supérieur à > 0,6 et inférieur à < 2,2,
sachant que le revêtement polymère à plasma comprend de l'hydrogène et/ou du fluor,
sachant que les rapports suivant s'appliqueent :
1,8 : 1 < n (H et/ou F) : n (C) < 3,6 : 1
de préférence
2,2 : 1 < n (H et/ou F) : n (C) < 3,3 : 1.

2. Article selon la revendication 1, dans lequel le revêtement contient par rapport à son nombre total d'atomes sans hydrogène et/ou fluor
- au moins 22% et au maximum 27% d'atomes de Si en pourcentage atomique,
- au moins 25% et au maximum 50% d'atomes de O en pourcentage atomique, et
- au moins 25% et au maximum 50% d'atomes de C en pourcentage atomique.

3. Article selon la revendication 1,
**caractérisé en ce que** la valeur de rugosité Rₐ de la surface du revêtement polymère à plasma est inférieure à 1 µm, de préférence inférieure à 0,3 µm, et de manière encore préférée inférieure à 0,1 µm.

4. Article selon l'une quelconque des revendications précédentes,
**caractérisé en ce que** le revêtement polymère à plasma comporte un angle de contact avec l'eau supérieur à 90°, de préférence supérieur à 95°, de préférence supérieur à 100°.

5. Article selon l'une quelconque des revendications précédentes,
**caractérisé en ce que** le revêtement polymère à plasma est relié au substrat par une couche intermédiaire.

6. Article selon l'une quelconque des revendications précédentes,
**caractérisé en ce que** l'article est un des objets suivants :
une jante ; un enjoliveur ; un profilé en aluminium, en particulier pour des fenêtres ou des douches, une fenêtre ; des habillages ; des pales d'éolienne ; un cache en métal, en particulier destiné à des maisons ; un cache et des habillages pour des cuisines ou des appareils de cuisine ; un écran, en particulier pour des cuisines ; un vitrage ; une partie de carrosserie automobile ; un composant de roue de moteur ; un récipient pour boisson ; un récipient à couleur ; un récipient à encre ; une cartouche d'encre ; une bouteille ; un appareil de cuisine ; une poêle à frire ; un panneau signalétique ; un panneau d'avertissement ; des contenants réutilisables destinés à des produits alimentaires, tels que des bouteilles ou des fûts.
